(19) **Europäisches Patentamt / European Patent Office / Office européen des brevets**

(11) **EP 4 657 104 A1**

(12) # EUROPEAN PATENT APPLICATION
published in accordance with Art. 153(4) EPC

(43) Date of publication:
**03.12.2025 Bulletin 2025/49**

(21) Application number: **23918460.9**

(22) Date of filing: **07.08.2023**

(51) International Patent Classification (IPC):
**G01R 33/26** (2006.01)    **G01N 21/64** (2006.01)
**G01N 24/00** (2006.01)    **G01R 33/032** (2006.01)

(52) Cooperative Patent Classification (CPC):
**G01N 21/64; G01N 24/00; G01R 33/032;
G01R 33/24; G01R 33/26**

(86) International application number:
**PCT/JP2023/028771**

(87) International publication number:
**WO 2024/157500 (02.08.2024 Gazette 2024/31)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.01.2023  JP 2023011084**

(71) Applicants:
• **Sumida Corporation
Tokyo 100-0042 (JP)**
• **Kyoto University
Kyoto-shi, Kyoto 606-8501 (JP)**

(72) Inventors:
• **SAKO Akifumi
Natori City, Miyagi 9811226 (JP)**
• **YOSHII Yoshiharu
Natori City, Miyagi 9811226 (JP)**
• **TAKEMURA Yuki
Natori City, Miyagi 9811226 (JP)**
• **MIZUOCHI Norikazu
Kyoto-shi, Kyoto 606-8501 (JP)**
• **NAKAMURA Masaya
Kyoto-shi, Kyoto 606-8501 (JP)**

(74) Representative: **Winter, Brandl - Partnerschaft
mbB
Alois-Steinecker-Straße 22
85354 Freising (DE)**

(54) ## MEASUREMENT DEVICE AND MEASUREMENT METHOD

(57)    A measured field is applied to a measurement magnetic resonance member (1) but is not applied to a reference magnetic resonance member (1R). High frequency magnetic field generators (2, 2R) perform an electron spin quantum operation for the measurement magnetic resonance member (1) and the reference magnetic resonance member (1R) by using a measurement microwave and a reference microwave, respectively. A power divider (11a) distributes a high frequency current from a high frequency power source (11) to the high frequency magnetic field generators (2, 2R). An optical distributor (21) distributes excitation light from a light emitting device (12) to the measurement magnetic resonance member (1) and the reference magnetic resonance member (1R). Light receiving devices (13, 13R) receive fluorescent from the measurement magnetic resonance member (1) and the reference magnetic resonance member (1R), respectively, and generate fluorescent sensor signals, respectively. An arithmetic processing part (30) derives a measurement value based on the fluorescent sensor signals.

EP 4 657 104 A1

Fig. 1

**Description**

TECHNICAL FIELD

The present invention relates to a measurement device and a measurement method.

BACKGROUND ART

A magnetic field measurement device performs magnetic measurement using optically detected magnetic resonance (ODMR) in which electron spin resonance of a sensing member such as a diamond structure having nitrogen and lattice defects (NV center: Nitrogen Vacancy Center) is utilized. In the ODMR, a static magnetic field is applied to a magnetic resonance member such as diamond that has the NV center in separation from a measured magnetic field, and at the same time, laser light (excitation light for initialization and measurement) and a microwave are applied in a predetermined measurement sequence. An amount of light of fluorescence emitted from the magnetic resonance member is detected and a magnetic flux density of the measured magnetic field is derived based on the amount of light.
For instance, in Ramsey pulse sequence, (a) excitation light is irradiated to an NV center, (b) a first $\pi/2$ pulse of a microwave is applied to the NV center, (c) a second $\pi/2$ pulse of the microwave is applied to the NV center at a predetermined time interval tt from the first $\pi/2$ pulse, (d) a light emission amount from the NV center is measured by irradiating the excitation light to the NV center, and (e) a magnetic flux density is derived based on the measured light emission amount. Further, in a spin echo pulse sequence, (a) the excitation light is irradiated to the NV center, (b) the first $\pi/2$ pulse of the microwave is applied to the NV center at a phase of 0 degrees of a measured magnetic field, (c) a $\pi$ pulse of the microwave is applied to the NV center at a phase of 180 degrees of the measured magnetic field, (d) the second $\pi/2$ pulse of the microwaves is applied to the NV center at a phase of 360 degrees of the measured magnetic field, (e) the light emission amount from the NV center is measured by irradiating the excitation light to the NV center, and (f) the magnetic flux density is derived based on the measured light emission amount.
A certain sensor device measures a magnetic field by nuclear magnetic resonance using a diamond sensor including the NV center as mentioned above (for instance, refer to Patent Document 1).

PRIOR ART DOCUMENT

PATENT DOCUMENT

Patent Document 1: Japanese Patent Publication Number: 2019-138772.

SUMMARY OF THE INVENTION

PROBLEMS TO BE SOLVED BY THE INVENTION

In optically detected magnetic resonance that utilizes electron spin resonance of a sensing member, because a detection signal obtained from fluorescence is weak, it is susceptible to noise and measurement accuracy would decrease.
The present invention has been made in consideration of the above problems, and has an object that is to obtain a measurement device and a measurement method that suppress a noise component and improve measurement accuracy.

MEANS FOR SOLVING THE PROBLEMS

A measurement device according to the present invention includes a measurement magnetic resonance member capable of an electron spin quantum operation by a measurement microwave and to which a measured field is applied, a measurement high frequency magnetic field generator which performs the electron spin quantum operation of the measurement magnetic resonance member by the measurement microwave in accordance with a predetermined measurement sequence, a reference magnetic resonance member capable of an electron spin quantum operation by a reference microwave and to which the above mentioned measured field is not applied, a reference high frequency magnetic field generator that performs the electron spin quantum operation of the reference magnetic resonance member by the reference microwave in accordance with the above-mentioned predetermined measurement sequence, a high frequency power source which generates a high frequency current for the measurement microwave and the reference microwave, a power divider which distributes the high frequency current to the measurement high frequency magnetic field generator and the reference high frequency magnetic field generator, a light emitting device which emits excitation light to be irradiated to the measurement magnetic resonance member and the reference magnetic resonance member, an optical distributor which distributes the excitation light to the measurement magnetic resonance member and the reference magnetic resonance member, a measurement light receiving device which receives fluorescence emitted by the measurement magnetic resonance member in response to the excitation light and generates a first fluorescence sensor signal corresponding to an intensity of the received fluorescence, a reference light receiving device which receives fluorescence emitted by the reference magnetic resonance member in response to the excitation light and generates a second fluorescence sensor signal corresponding to an intensity of the received fluorescence, and an arithmetic processing part which derives a measurement value based on the first fluorescence sensor signal and the second fluorescence sensor signal.

A measurement method according to the present invention includes (a) creating a state in which a measured field is applied to a measurement magnetic resonance member capable of an electron spin quantum operation by a reference microwave and the measured field is not applied to a reference magnetic resonance member capable of an electron spin quantum operation by a reference microwave, (b) in the state, performing the electron spin quantum operation of the measurement magnetic resonance member by the measurement microwave and performing the electron spin quantum operation of the reference magnetic resonance member by the reference microwave according to a predetermined measurement sequence by generating the measurement microwave and the reference microwave due to distribution of a high frequency current to a measurement high frequency magnetic field generator and a reference high frequency magnetic field generator, (c) in the state, distributing excitation light to the measurement magnetic resonance member and the reference magnetic resonance member to irradiate the excitation light to the measurement magnetic resonance member and the reference magnetic resonance member, receiving fluorescence emitted in response to the excitation light by the measurement magnetic resonance member to generate a first fluorescence sensor signal corresponding to an intensity of the received fluorescence, and receiving fluorescence emitted in response to the excitation light by the reference magnetic resonance member to generate a second fluorescence sensor signal corresponding to an intensity of the received fluorescence, and (d) deriving a measurement value based on the first fluorescence sensor signal and the second fluorescence sensor signal.

EFFECTS OF THE INVENTION

According to the present invention, it is possible to obtain a measurement device and a measurement method that suppress a noise component and improve measurement accuracy.

BRIEF DESCRIPTION OF THE DRAWINGS

[Fig. 1] Fig. 1 is a block diagram that shows a configuration of a measurement device according to a first embodiment of the present invention.
[Fig. 2] Fig. 2 is a diagram that shows an example of a measurement sequence.
[Fig. 3] Fig. 3 is a diagram that explains an excitation light, a first fluorescence sensor signal PL(t), and a CMR signal CMR_SIG(t).
[Fig. 4] Fig. 4 is a diagram that shows an example of a frequency characteristic of a window function.
[Fig. 5] Fig. 5 is a flow diagram that explains an operation of the measurement device according to the first embodiment.
[Fig. 6] Fig. 6 is a block diagram that shows a configuration of a measurement device according to a second embodiment of the present invention.
[Fig. 7] Fig. 7 is a diagram that explains excitation light, a first fluorescence sensor signal PL(t), a CMR signal CMR_SIG(t), and a detection signal SD(t).
[Fig. 8] Fig. 8 is a flow diagram that explains an operation of the measurement device according to the second embodiment.
[Fig. 9] Fig. 9 is a diagram that shows an example of a pulse width of a measurement microwave and a pulse width of a reference microwave according to a fourth embodiment.

EMBODIMENTS FOR CARRYING OUT THE INVENTION

Embodiments according to the present invention will be explained below with reference to the drawings.

FIRST EMBODIMENT

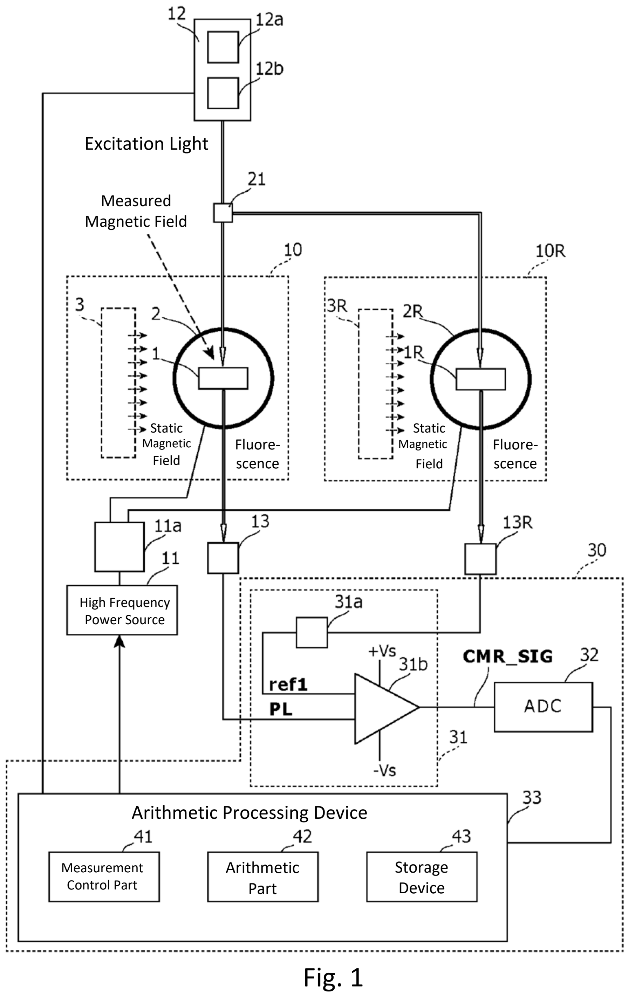

Fig. 1 is a block diagram that shows a configuration of a measurement device according to a first embodiment of the present invention. The measurement device shown in Fig. 1 has a measurement sensor part 10, a reference sensor part 10R, a high frequency power source 11, a power divider 11a, a light emitting device 12, a measurement light receiving device 13, a reference light receiving device 13R, a light (optical) distributor 21, and an arithmetic processing part 30.

The measurement sensor part 10 detects a field to be measured (a measured field, for instance, a magnetic field such as an intensity and a direction of the magnetic field, or an electric field) at a predetermined position (for instance, on or above a surface of an object to be inspected, or a position facing a secondary coil of a flux transformer explained below). Further, the field to be measured (the measured field) may be an alternating current field with a single frequency, an alternating current field with a predetermined cycle having a plurality of frequency components, or a direct current field.

In this embodiment, the measurement sensor part 10 has a measurement magnetic resonance member 1, a measurement high frequency magnetic field generator 2, and a measurement static magnetic field generator 3 based on the ODMR.

The measurement magnetic resonance member 1 has a crystal structure. An electron spin quantum state of the measurement magnetic resonance member 1 changes in correspond with the measured field (here, a magnetic field), and at the same time, the measurement magnetic resonance member 1 is a member in which it is capable of an electron spin quantum operation by a microwave at a frequency that corresponds to an arrangement direction of defects and impurities in a crystal lattice (based on Rabi oscillation). That is, the measurement magnetic resonance member 1 is placed at a measurement position to which the measured field is applied.

In this embodiment, the measurement magnetic resonance member 1 is an optically detected magnetic resonance member having a plurality (that is, an ensemble) of specific color centers. This specific color center has an energy level capable of Zeeman splitting, and at the same time, can take a plurality of directions in which shift widths of the energy level at the time of Zeeman splitting are different from each other.

Here, the measurement magnetic resonance member 1 is a member such as a diamond that includes a plurality of NV (Nitrogen Vacancy) centers as a specific color center of a single category (or type). In the case of the NV center, a ground state is a triplet state of ms = 0, +1, and -1 and a level of ms = +1 and a level of ms = -1 undergo Zeeman splitting. When the NV center transitions from an excited state at the levels of ms = +1 and ms = - 1 to the ground state, the NV center is accompanied by fluorescence at a predetermined proportion and the remaining proportion of the NV center transitions from the excited state (ms = +1 or ms = -1) to the ground state (ms = 0) with non-radiation.

Note that the color center included in the measurement magnetic resonance member 1 may be a color center other than the NV center.

The measurement high frequency magnetic field generator 2 applies a microwave (referred to as measurement microwaves) to the measurement magnetic resonance member 1 so as to perform an electron spin quantum operation of the measurement magnetic resonance member 1. For instance, the measurement high frequency magnetic field generator 2 is a plate-shaped coil and has a substantially circular coil part that emits the microwave and terminal parts that extend from both ends of the coil part and are fixed to a substrate.

Further, the measurement static magnetic field generator 3 applies a static magnetic field (a DC magnetic field) (referred to as a measurement static magnetic field) to the measurement magnetic resonance member 1 so that the energy levels of a plurality of specific color centers (here, a plurality of NV centers) in the measurement magnetic resonance member 1 undergo Zeeman splitting. Here, the measurement static magnetic field generator 3 is a permanent magnet, such as a ferrite magnet, an alnico magnet, or a samarium cobalt magnet. Note that the measurement static magnetic field generator 3 may be an electromagnet.

In this embodiment, because an application direction of the above-mentioned static magnetic field is the same as an application direction of the above-mentioned measured magnetic field, by applying the above-mentioned static magnetic field, the change of the fluorescence intensity at the above-mentioned dip frequency is enhanced and the sensitivity is increased.

Further, in this embodiment, the measurement magnetic resonance member 1 is provided with the plurality of color centers (here, the NV centers) in which it is capable of the electron spin quantum operation by the above-mentioned measurement microwaves. The measurement static magnetic field generator 3 applies the substantially uniform static magnetic field to a predetermined region (an irradiation region of the excitation light) of the measurement magnetic resonance member 1. For instance, the static magnetic field is applied as a difference or a ratio between the maximum value and the minimum value of the intensities of the static magnetic field in the predetermined region is equal to or less than a predetermined value.

Further, in the measurement magnetic resonance member 1, as the arrangement direction of the above-mentioned defects and impurities is substantially coincident with the above-mentioned direction of the static magnetic field (and the direction of the applied magnetic field), the crystal of the measurement magnetic resonance member 1 is formed, the direction of the measurement magnetic resonance member 1 is set, and the measurement static magnetic field generator 3 is arranged.

On the other hand, the reference sensor part 10R has a configuration similar to that of the measurement sensor part 10. However, the reference sensor part 10R is arranged at a position to which the measured field is not applied (to a reference magnetic resonance member 1R). When necessary, a magnetic shield may be provided to prevent the measured field from being applied to the reference sensor part 10R.

In this embodiment, the reference sensor part 10R has the reference magnetic resonance member 1R similar to (or same as) the measurement magnetic resonance member 1, a reference high frequency magnetic field generator 2R similar to (or same as) the measurement high frequency magnetic field generator 2, and a reference static magnetic field generator 3R similar to (or same as) the measurement static magnetic field generator 3 based on the ODMR.

That is, the reference high frequency magnetic field generator 2R applies a microwave (referred to as reference microwaves) to the reference magnetic resonance member 1R so as to perform an electron spin quantum operation of the reference magnetic resonance member 1R. Further, the reference static magnetic field generator 3R applies a static magnetic field (a DC magnetic field) (referred to as a reference static magnetic field) to the reference magnetic resonance member 1R so that the energy levels of a plurality of specific color centers (here, a plurality of NV centers) in the reference magnetic resonance member 1R undergo Zeeman splitting.

Here, the measurement magnetic resonance member 1 is a diamond member having an NVC. Further, the reference magnetic resonance member 1R is a diamond member having physical properties equivalent to those of the measurement magnetic resonance member 1 and equivalent resonance frequency conditions of an NV axis in the ODMR. Further, the reference high frequency magnetic field generator 2R is a microwave coil that generates a magnetic field intensity equivalent to that of the measurement high frequency magnetic field generator 2 in response to an input of a high frequency current. In addition, the reference static magnetic field generator 3R is a static magnetic field magnet that generates a static magnetic field intensity equivalent to that of the measurement static magnetic field generator 3.

Furthermore, a high frequency power source 11 generates a high frequency current for the measurement microwaves and the reference microwaves mentioned above. A power divider 11a distributes the high frequency current to the measurement high frequency magnetic field generator 2 and the reference high frequency magnetic field generator 2R. Here, the power divider 11a is a 0-degrees power divider and equally (by 1 : 1) distributes the high frequency current to the measurement high frequency magnetic field generator 2 and the reference high frequency magnetic field generator 2R.

For example, the measurement high frequency magnetic field generator 2 and the reference high frequency magnetic field generator 2R respectively have a coil part. Further, the coil part conducts two currents that are mutually in parallel at a predetermined interval so as to sandwich the magnetic resonance members 1 and 1R at both end surface parts of the coil part and emits the above-mentioned microwaves. Here, the coil part is a plate-shaped coil, however, because the current of the microwave flows through the end surface part of the coil part due to a skin effect, two currents are formed.

In the case of the NV center, since the color center is formed by a defect (vacancy) (V) and nitrogen (N) as an impurity in the diamond crystal, there are four possible positions for adjacent nitrogen (N) with respect to the defect (vacancy) (V) in the diamond crystal (that is, the arrangement directions of a pair of the vacancy and the nitrogen). Sub-levels (that is, the energy level from the ground) after Zeeman splitting respectively corresponding to these arrangement directions are different from each other. Therefore, in a characteristic of a fluorescence intensity after Zeeman splitting due to a static magnetic field with respect to a frequency of the microwave, in correspond with each direction i (i = 1, 2, 3, and 4), four pairs of dip frequencies (fi+, fi-) that are different from one another appear. Here, the above-mentioned frequency of the microwave (wavelength) is set in correspond with any of the dip frequencies of these four pairs of dip frequencies.

Furthermore, in this embodiment, in order to irradiate the measurement magnetic resonance member 1 and the reference magnetic resonance member 1R with the excitation light, an optical system from the light emitting device 12 to the measurement magnetic resonance member 1 and the reference magnetic resonance member 1R is provided. In addition, in order to detect fluorescence from the measurement magnetic resonance member 1, an optical system from the measurement magnetic resonance member 1 to the measurement light receiving device 13 is provided. Further, in order to detect fluorescence from the reference magnetic resonance member 1R, an optical system from the reference magnetic resonance member 1R to the reference light receiving device 13R is provided.

The light emitting device 12 has a light source 12a, such as a laser diode, and an optical modulator 12b. The light source 12a emits laser light having a predetermined wavelength as the excitation light to irradiate onto the measurement magnetic resonance member 1 and the reference magnetic resonance member 1R. The optical modulator 12b is, for instance, an electro-optical modulator (EOM) or an acousto-optical modulator (AOM), and periodically turns on and off (transmits and blocks) the excitation light from the light source 12a according to a predetermined measurement sequence.

Further, the measurement light receiving device 13 has, such as a photodiode or a phototransistor, as a light receiving element, receives the fluorescence emitted by the measurement magnetic resonance member 1 in correspond with the excitation light, and generates a first fluorescence sensor signal PL corresponding to the intensity of the fluorescence. The reference light receiving device 13R has, such as a photodiode or a phototransistor, as a light receiving element, receives the fluorescence emitted by the reference magnetic resonance member 1R in correspond with the excitation light, and generates a second fluorescence sensor signal ref1 corresponding to the intensity of the fluorescence. These fluorescences are concentrated toward the measurement light receiving device 13 and the reference light receiving device 13R by an optical system such as a compound parabolic concentrator (CPC), respectively.

Further, a measurement principle will be explained.

As expressed in the following equation, an intensity I of the excitation light mentioned above is the sum of an original intensity $I_{laser}$ and a noise component intensity (an intensity of noise) $I_{noise}$. Note that this noise component of the excitation light is generated due to, for instance, fluctuation in a power supply voltage of the light emitting device 12 and fluctuation in a light emission amount from the light source, and has a frequency in a range of, for instance, about kHz order to about 100 kHz order.

$$I = I_{laser} + I_{noise}.$$

Further, a level of the first fluorescence sensor signal PL is basically proportional to the intensity I of the excitation light. However, due to the change in the electron spin quantum state with respect to the measured field, the fluorescence intensity at the start of the excitation light irradiation during the measurement becomes low. Thereafter, until the influence of the change in the electron spin quantum state with respect to the measured field disappears, the fluorescence intensity gradually increases. Therefore, a level variation $\alpha_{cont}(t)$ of the first fluorescence sensor signal PL is derived as a signal indicating the measured field. The first fluorescence sensor signal PL is expressed by the following equation.

$$PL\,(t) = \alpha(t) \times I = (\alpha_{init} + \alpha_{cont}(t)) \times I = (\alpha_{init} + \alpha_{cont}(t)) \times (I_{laser} + I_{noise}).$$

Further, $\alpha_{init}$ is a coefficient indicating a portion (a portion that is not affected by changes in the electron spin quantum state with respect to the measured field) being proportional to the intensity I of the excitation light.

Furthermore, since this level variation $\alpha_{cont}(t)$ contains a noise component $\alpha_{MW}(t)$ due to the measurement microwave, the above-mentioned PL(t) is expressed by the following equation.

$$PL(t) = (\alpha_{init} + \alpha_{MW}(t) + \alpha_{AC}(t)) \times (I_{laser} + I_{noise}).$$

Here, $\alpha_{AC}(t)$ is the component due to the change in the electron spin quantum state with respect to the measured field ($\alpha_{cont}(t)$ minus the noise component $\alpha_{MW}(t)$).

On the other hand, a level ref1 of the above-mentioned second fluorescence sensor signal is expressed by the following equation. Note that since the measured field is not applied to the reference magnetic resonance member 1R, $\alpha_{AC}(t)$ due to the measured field is not included.

$$ref1 = \beta \times (\alpha_{init} + \alpha_{MW}(t)) \times (I_{laser} + I_{noise}).$$

Where, $\beta$ is a constant.

Further, common mode rejection is performed on PL(t) so as to generate a common mode rejection signal (a CMR signal). The CMR signal CMR_SIG(t) is expressed by the following equation. As a result, the influence of $I_{noise}$ and the influence of $\alpha_{MW}(t)$ are removed.

$$CMR\_SIG(t) = PL(t) - ref1/\beta = \alpha_{AC}(t) \times (I_{laser} + I_{noise}).$$

A peak value (a value at t = 0) and a time integration value of the CMR signal CMR_SIG(t) are correlated with an intensity of the measured field. Therefore, the intensity of the measured field is derived from such as the peak value and the time integration value of the CMR signal CMR_SIG(t) by specifying a correspondence relation among the peak value and the time integration value of the CMR signal CMR_SIG(t), and the intensity of the measured field by such as experiments in advance and using a calculation equation or a table that shows the correspondence relation.

Based on such the measurement principle, the following configuration is provided.

The measurement device shown in Fig. 1 further has a light distributor 21 as optical elements such as a beam splitter or an optical sampler on an optical path of the excitation light from the light emitting device 12 to the magnetic resonance member 1. The light distributor 21 branches a part of the excitation light from the excitation light and emits the part of the excitation light in a different direction as the reference light. For instance, the light distributor 21 is a deflection independent beam splitter.

Further, as mentioned above, the first fluorescence sensor signal PL and the second fluorescence sensor signal ref1 are generated by the light receiving devices 13 and 13R.

Furthermore, in the measurement device shown in Fig. 1, the arithmetic processing part 30 has a CMR arithmetic part 31 as an analog calculation circuit, an analog/digital converter 32, and an arithmetic processing device 33.

The CMR arithmetic part 31 performs the common mode rejection with respect to the first fluorescence sensor signal PL based on the second fluorescence sensor signal ref1 and generates the CMR signal CMR_SIG based on the common mode rejection. Specifically, the CMR arithmetic part 31 has a coefficient part 31a and a differential amplifier 31b. The coefficient part 31a multiplies the second fluorescence sensor signal ref1 by a coefficient $(1/\beta)$ (a known constant) (or divides the second fluorescence sensor signal ref1 by the coefficient $\beta$). Further, the differential amplifier 31b subtracts a signal obtained by multiplying the second fluorescence sensor signal by the coefficient $(1/\beta)$ (or dividing the second fluorescence sensor signal ref1 by the coefficient $\beta$) from the first fluorescence sensor signal PL. As a result, the CMR signal CMR_SIG is generated.

Note that the coefficient part 31a as a circuit may be provided. Alternatively, without providing the coefficient part 31a, the second fluorescence sensor signal with an intensity, which is obtained by adjusting a gain of the light receiving device 13R and multiplying by coefficient $(1/\beta)$ (or with an intensity divided by the coefficient $\beta$), may also be possible to output.

The analog/digital converter 32 digitizes the CMR signal CMR_SIG with a predetermined number of bits and a predetermined sampling period (speed), and outputs the digitized CMR signal CMR_SIG to the arithmetic processing device 33.

The arithmetic processing device 33 has, for instance, a computer, executes a signal processing program by the computer, and operates as various processing units. In this embodiment, the arithmetic processing device 33 causes the computer to operate as a measurement control part 41 and an arithmetic part 42, and also has a nonvolatile storage device 43.

The signal processing program is stored in the storage device 43. The computer is equipped with, for instance, a CPU (Central Processing Unit), a ROM (Read Only Memory), and a RAM (Random Access Memory), and operates as the measurement control part 41 and the arithmetic part 42 by loading the signal processing program into the RAM and executing the signal processing program by the CPU.

According to a predetermined measurement sequence, the measurement control part 41 (a) controls the high frequency power source 11 and the light emitting device 12 and (b) obtains the digitized CMR signal CMR_SIG as mentioned above, stores them in the RAM or the storage device 43, and causes the arithmetic part 42 to derive a measurement value of the measured field.

This measurement sequence is set according to such as a frequency of the measured field. For instance, when the measured field is an alternating current field with a relatively high frequency, a spin echo pulse sequence (such as a Hahn echo sequence) is applied as this measurement sequence. However, the measurement sequence is not limited to the above configuration. Further, for instance, when the measured field is an alternating current field with a relatively low frequency, a physical field can be measured several times in one period (cycle) of the measured field by using a Ramsey pulse sequence (that is, a measurement sequence for a direct current field) so that the measured field (an intensity, a waveform, and so on) may be specified based on these measurement results.

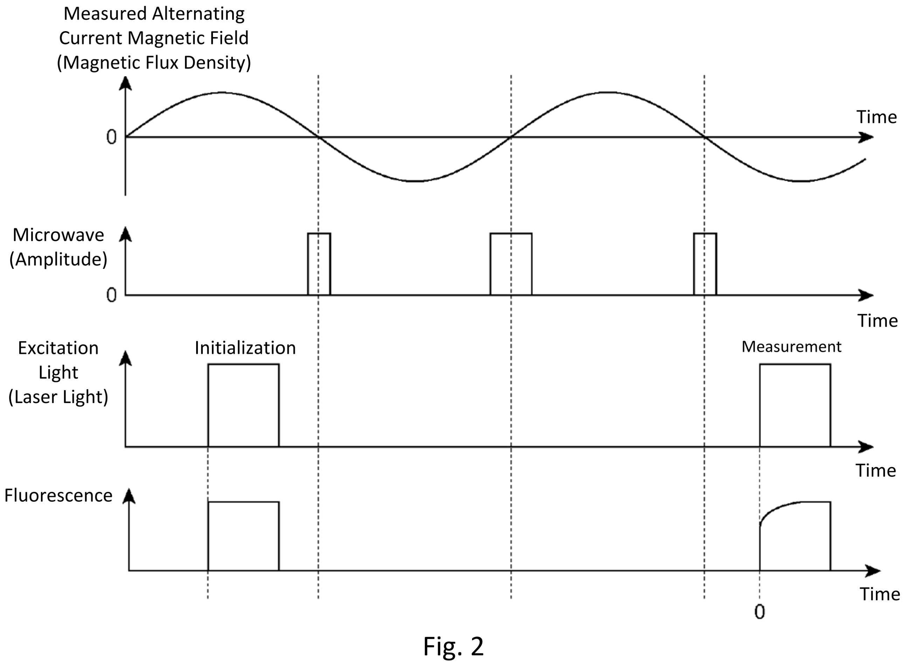

Fig. 2 is a diagram that shows an example of a measurement sequence. Fig. 2 shows the timing of a microwave pulse and the irradiation timing of the excitation light (twice for initialization and measurement) with respect to the measured magnetic field in the case of a spin echo pulse sequence. As shown in Fig. 2, fluorescence is detected during the irradiation period of the excitation light.

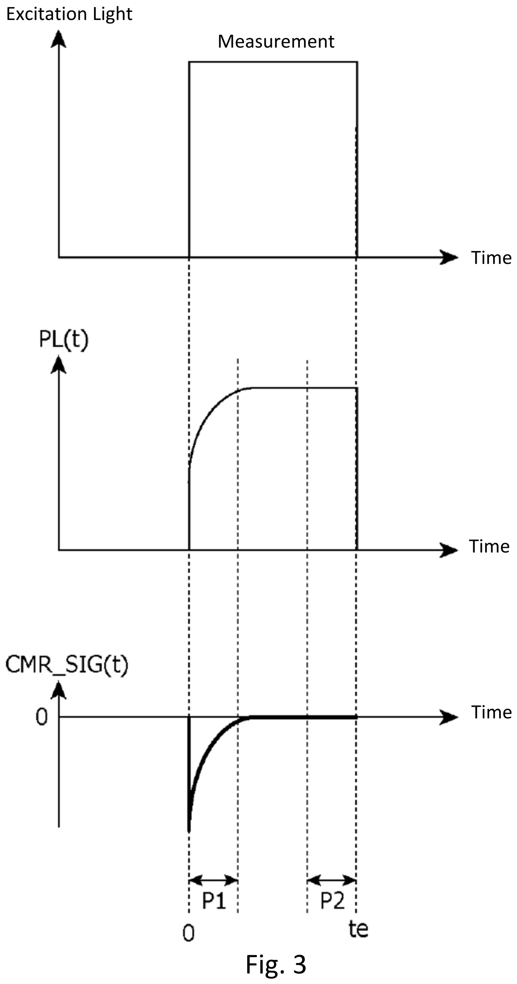

Fig. 3 is a diagram that explains an excitation light, a first fluorescence sensor signal PL(t), and a CMR signal CMR_SIG(t). As shown in Fig. 3, the excitation light has a rectangular pulse-like intensity during the irradiation period. The first fluorescence sensor signal PL(t) becomes a pulse signal that gradually rises and converges to a constant level during the irradiation period. Further, the CMR signal CMR_SIG(t) is obtained by the common mode rejection.

Further, the arithmetic part 42 derives the measurement value (that is, for instance, a magnetic flux density or a waveform of the magnetic field) of the measured field based on the digitized CMR signal CMR_SIG(t).

Furthermore, the arithmetic part 42 performs a digital filtering process for removing a noise on the digitized CMR signal CMR_SIG(t). According to the embodiment, in the digital filtering process, the arithmetic part 42 applies a window function to the digitized CMR signal CMR_SIG(t) so as to attenuate a high frequency component (high-frequency noise component) of the signal. The window function is a Finite Impulse Response (FIR) filter.

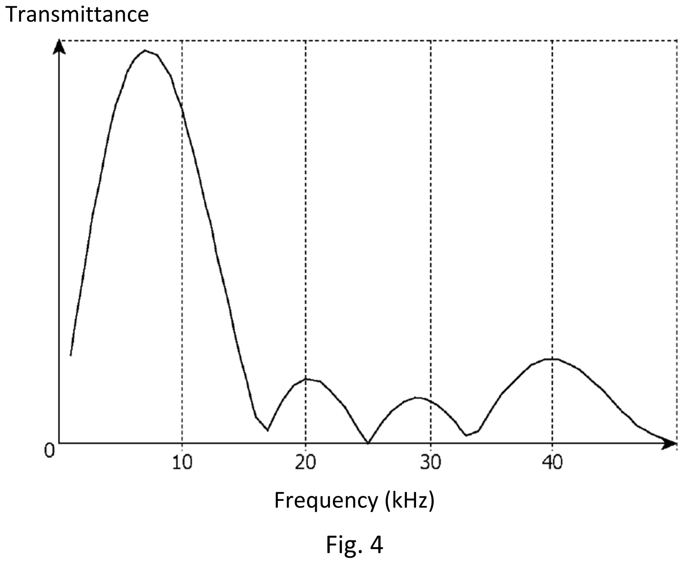

Fig. 4 is a diagram that shows an example of a frequency characteristic of a window function. The above-mentioned window function has the frequency characteristic as shown in, for instance, Fig. 4, and attenuates the high-frequency noise component (in this case, components of about 10 kHz or higher).

The above-mentioned FIR filter, for example, (a) respectively integrates (adds up) values of the digitized CMR signals that are obtained a plurality of times (a predetermined number of samplings) during the first half and the second half of the irradiation period of the excitation light, and (b) calculates a difference between an integrated value (a total sum or an average) of the CMR signals with respect to the first half and an integrated value (a total sum or an average) of the CMR signals with respect to the second half so as to remove the noise components in the CMR signals.

As shown in, for instance, Fig. 3, during a period P1 in the first half (a period of a predetermined length of time from the start time of the irradiation ($t = 0$)), the values of CMR signal of a predetermined number of samplings are obtained, and during a period P2 in the second half (a period of a predetermined length of time until the end time of the irradiation ($t = te$)),

the values of CMR signal of a predetermined number of samplings are obtained. The integrated value of the second half is subtracted from the integrated value of the first half, and a value of the subtraction result is obtained. By setting the obtained value of the subtraction result as a value of the CMR signal, the noise component in the CMR signal is suppressed.

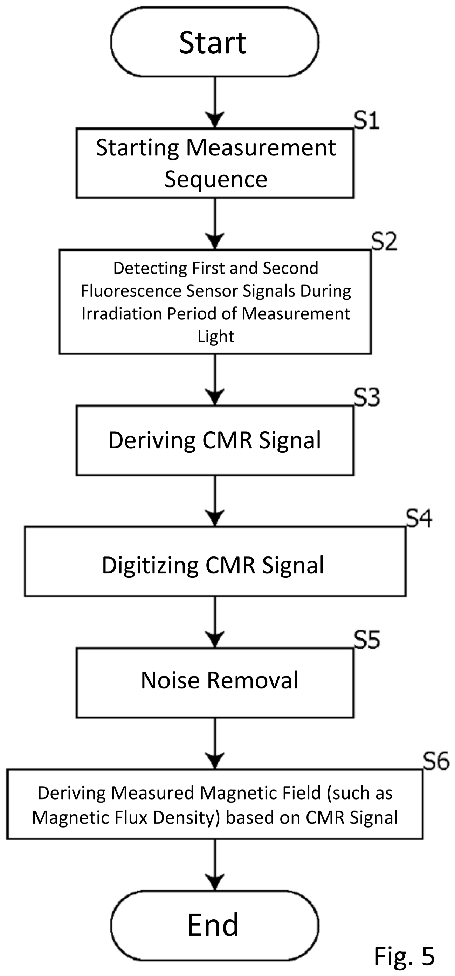

Next, an operation of the measurement device according to the first embodiment will be explained. Fig. 5 is a flow diagram that explains the operation of the measurement device according to the first embodiment.

The measurement sensor part 10 (measurement magnetic resonance member 1) is placed at a position in which the measured field is applied, and a reference sensor part 10R (reference magnetic resonance member 1R) is placed at a position in which the measured field is not applied. As a result, the measured field is applied to the measurement magnetic resonance member 1, while the measured field is not applied to the reference magnetic resonance member 1R.

Next, in this state, the measurement control part 41 starts a predetermined measurement sequence (step S1) and, according to the measurement sequence, causes the light emitting device 12 to emit excitation light and causes the measurement high frequency magnetic field generator 2 and the reference high frequency magnetic field generator 2R to emit microwaves.

This single excitation light is distributed to the measurement magnetic resonance member 1 and the reference magnetic resonance member 1R, and at the same time, a single high frequency current is distributed to the measurement high frequency magnetic field generator 2 and the reference high frequency magnetic field generator 2R. As a result, a predetermined measurement sequence is executed in parallel in the measurement sensor part 10 (the measurement magnetic resonance member 1) and the reference sensor part 10R (the reference magnetic resonance member 1R).

During the irradiation period of the excitation light at the time of measurement, the measurement light receiving device 13 outputs the first fluorescence sensor signal PL (an analog signal), and the reference light receiving device 13R outputs the reference light sensor signal ref1 (an analog signal) (step S2).

Further, the CMR arithmetic part 31 performs the common mode rejection with respect to the first fluorescence sensor signal PL(t) based on the second fluorescence sensor signal ref1(t) so that the CMR signal CMR_SIG(t) is generated (step S3). In addition, the CMR signal CMR_SIG(t) is digitized by the analog/digital converter 15 (step S4).

In the arithmetic processing device 33, the measurement control part 41 obtains this CMR signal CMR_SIG(t) (a digital signal), and the arithmetic part 42 applies a window function to the CMR signal so as to remove high-frequency noise components (for instance, components of 10 kHz or higher) in the CMR signal CMR_SIG(t) (step S5). Note that the arithmetic part 42 may further perform integration (addition) and difference on a plurality of values of the CMR signal CMR_SIG(t) sampled a plurality of times (for instance, 1,000 times) so as to remove relatively low-frequency noise components (for instance, components from a few kHz to 10 kHz).

Furthermore, the arithmetic part 42 derives the measurement value (for instance, a magnetic flux density) of the measured field at the measurement position and the measurement timing (the execution timing of the measurement sequence) from the value of the CMR signal CMR_SIG(t) obtained by removing the noise as discussed above (step S6).

As mentioned above, according to the first embodiment, the measurement magnetic resonance member 1 is capable of the electron spin quantum operation by using the measurement microwave. Further, the measured field is applied to the measurement magnetic resonance member 1. The measurement high frequency magnetic field generator 2 performs the electron spin quantum operation of the measurement magnetic resonance member with the measurement microwaves according to the predetermined measurement sequence. The reference magnetic resonance member 1R is capable of the electron spin quantum operation by using the reference microwave. Further, the above-mentioned measured field is not applied to the reference magnetic resonance member 1R. The reference high frequency magnetic field generator 2R performs the electron spin quantum operation of the reference magnetic resonance member with the reference microwaves according to the above-mentioned predetermined measurement sequence. The high frequency power source 11 generates the high frequency current for the measurement microwave and the reference microwave. The power divider 11a distributes the high frequency current to the measurement high frequency magnetic field generator 2 and the reference high frequency magnetic field generator 2R. The light emitting device 12 emits the excitation light to irradiate onto the measurement magnetic resonance member 1 and the reference magnetic resonance member 1R. The light distributor 21 distributes the excitation light to the measurement magnetic resonance member 1 and the reference magnetic resonance member 1R. The measurement light receiving device 13 receives the fluorescence emitted by the measurement magnetic resonance member 1 in correspond with the excitation light and generates the first fluorescence sensor signal corresponding to the intensity of the received fluorescence. The reference light receiving device 13R receives the fluorescence emitted by the reference magnetic resonance member 1R in correspond with the excitation light and generates the second fluorescence sensor signal corresponding to the intensity of the received fluorescence. The arithmetic processing part 30 derives the measurement value based on the first fluorescence sensor signal and the second fluorescence sensor signal.

According to the above configuration, the influence of the noise components of the high frequency currents (measurement microwaves and reference microwaves) on the measurement values is suppressed (reduced). As a result, the measurement values of the measured field are derived with good accuracy.

SECOND EMBODIMENT

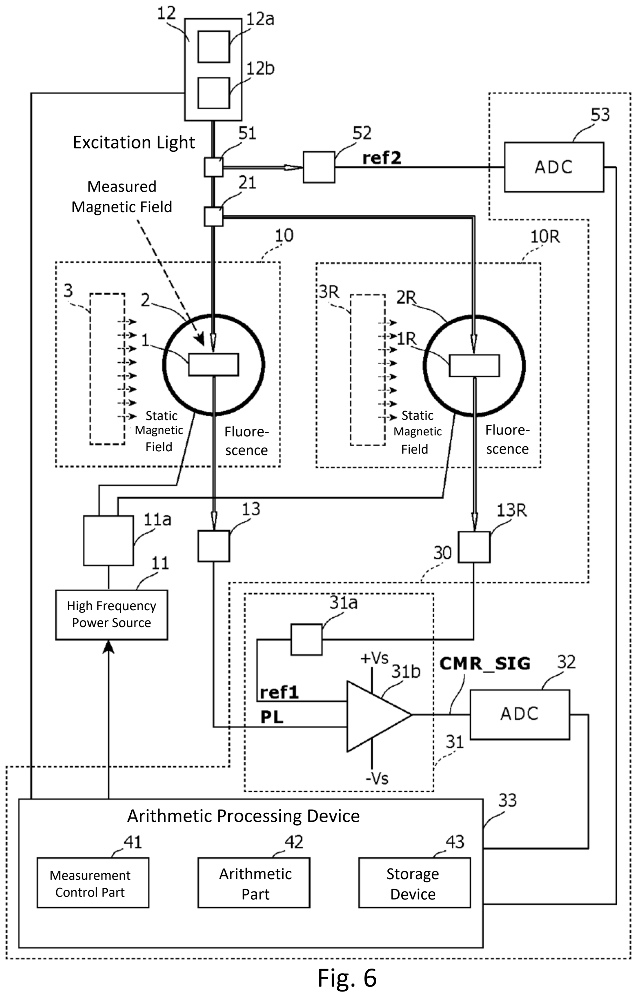

Fig. 6 is a block diagram that shows a configuration of a measurement device according to a second embodiment of the present invention. As shown in Fig. 6, the measurement device according to the second embodiment further includes a light distributor 51, a light receiving device 52, and an analog/digital converter 53.

The light distributor 51 is an optical element similar to the light distributor 21. Further, the light distributor 51 branches a part of the excitation light from the excitation light and emits the part of the excitation light in a different direction as reference light. In this configuration, the light distributor 51 is provided between the light distributor 21 and the light emitting device 12. However, instead of this configuration, the light distributor 51 may be provided at a downstream side of the light distributor 21 (between the light distributor 21 and the measurement sensor part 10, or between the light distributor 21 and the reference sensor part 10R).

The light receiving device 52 is a light receiving device similar to the light receiving devices 13 and 13R, receives the reference light branched by the light distributor 51, and outputs a reference light sensor signal ref2 corresponding to an intensity of the reference light.

The analog/digital converter 53 digitizes the reference light sensor signal ref2 with a predetermined number of bits and a predetermined sampling period (speed), and outputs the digitized reference light sensor signal ref2 to the arithmetic processing device 33.

In the second embodiment, the arithmetic part 42 generates a detection signal SD(t) based on the CMR signal CMR_SIG(t) and the reference light sensor signal ref2, and derives a measurement value of the measured field from the detection signal SD(t) in the same manner (by using the detection signal SD(t) instead of the CMR signal CMR_SIG(t) in the first embodiment).

Specifically, the reference light sensor signal ref2(t) is expressed by the following equation.

$$\mathrm{ref2(t)} = \gamma \times I = \gamma \times (I_{laser} + I_{noise}).$$

Where, $\gamma$ is a known constant.

Further, the above-mentioned detection signal SD(t) is derived as shown in the following equation.

$$\mathrm{SD(t)} = \alpha_{AC}(t) \ / \ \gamma \ (= \mathrm{CMR\_SIG(t)} \ / \ \mathrm{ref2(t)}).$$

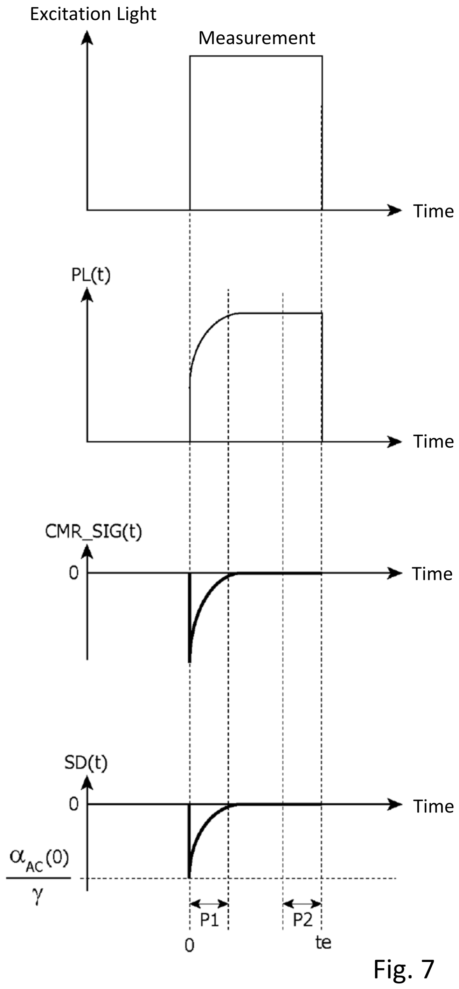

Fig. 7 is a diagram that explains the excitation light, the first fluorescence sensor signal PL(t), the CMR signal CMR_SIG(t), and the detection signal SD(t).

A peak value (a value at t = 0) and a time integration value of the detection signal SD(t) are correlated with an intensity of the measured field. Thus, a correspondence relation between the peak value and the time integration value of the detection signal SD(t) and the intensity of the measured field could be identified by such as experiments in advance. Therefore, the intensity of the measured field is derived from the peak value and the time integration value of the detection signal SD(t) shown in Fig. 7 by using a calculation equation or a table that shows the correspondence relation.

Further, in this embodiment, the analog/digital converter 32 operates faster than the analog/digital converter 53. The analog/digital converter 53 performs the digitizing operation with higher precision than the analog/digital converter 32.

For instance, the analog/digital converter 32 converts an input analog signal into a 20-bit digital signal at, for instance, 200M samples/sec. Further, the analog/digital converter 53 converts an input analog signal into a 24-bit digital signal at, for instance, 100k samples/sec.

Further, since the CMR signal changes relatively quickly, the CMR signal is sampled by the high-speed analog/digital converter 32, and as mentioned above, the noise removal based on a plurality of samples (samplings) is performed. On the other hand, as mentioned above, the reference light sensor signal ref2 is used for the division in order to theoretically remove the influence of the noise component $I_{noise}$ of the excitation light in the CMR signal. Thus, it is necessary to divide with accuracy according to a relative voltage level with respect to the voltage level of the first fluorescence sensor signal PL of the term of the product of the level variation $\alpha_{AC}(t)$ in the detected first fluorescence sensor signal PL and the noise component intensity $I_{noise}$. Therefore, the reference light sensor signal ref2 is sampled by the analog/digital converter 53 having relatively high precision.

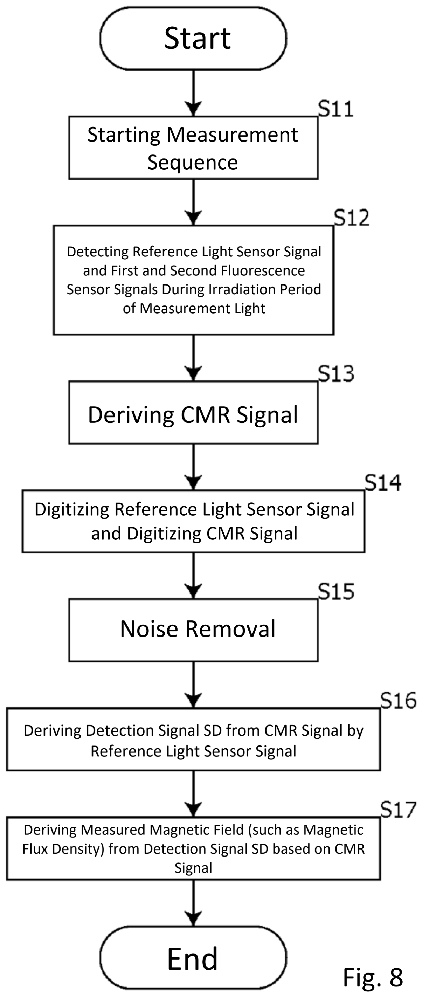

Next, an operation of the measurement device according to the second embodiment will be explained. Fig. 8 is a flow diagram that explains the operation of the measurement device according to the second embodiment.

In the same manner as the first embodiment, the measured field is applied to the measurement magnetic resonance member 1, while the measured field is not applied to the reference magnetic resonance member 1R.

Next, in the same manner as the first embodiment, in this state, the measurement control part 41 starts a predetermined measurement sequence (step S11) and causes the light emitting device 12 to emit the excitation light and causes the measurement high frequency magnetic field generator 2 and the reference high frequency magnetic field generator 2R to emit microwaves according to the measurement sequence.

As a result, during the irradiation period of the excitation light at the time of measurement, the measurement light receiving device 13 outputs the first fluorescence sensor signal PL (an analog signal), the reference light receiving device 13R outputs the reference light sensor signal ref1 (an analog signal), and the light receiving device 52 outputs the reference light sensor signal ref2 (step S12).

Further, in the same manner as the first embodiment, the CMR signal CMR_SIG(t) is generated (step S13) and digitized (step S14). Furthermore, the reference light sensor signal ref2 is also digitized (step S14).

In the arithmetic processing device 33, the measurement control part 41 obtains the CMR signal CMR_SIG(t) (a digital signal) and the reference light sensor signal ref2(t) (a digital signal). Further, the arithmetic part 42 performs the noise removal on the CMR signal CMR_SIG(t) in the same manner as the first embodiment (step S15).

In addition, the arithmetic part 42 derives a detection signal SD(t) from the CMR signal CMR_SIG(t) obtained, from which the noise has been removed, and the reference light sensor signal ref2(t) (step S16), and derives the measurement value of the measured field at the measurement position and the measurement timing (the execution timing of the measurement sequence) from the value of the detection signal SD(t) (step S17).

Further, the noise removal is performed on the CMR signal CMR_SIG(t) in the above configuration. However instead of the above configuration, the noise removal may be performed on the detection signal SD(t) by the same method.

Note that the other configurations and operations of the measurement device according to the second embodiment are the same as those explained in the first embodiment. Therefore, the explanations of the other configurations and operations of the measurement device according to the second embodiment will be omitted.

As mentioned above, according to the second embodiment, the reference light obtained by branching the excitation light is received so as to generate the reference light sensor signal ref2. Further, the measurement value is derived based on the reference light sensor signal ref2 together with the CMR signal.

As a result, since the influence of noise components of the excitation light on the measurement value is further suppressed (reduced), the measurement value of the measured field is derived with higher accuracy.

THIRD EMBODIMENT

In a third embodiment, when the intensities of the measurement microwave and the reference microwave are different due to, for instance, the characteristics of the power divider 11a, or the differences in the shapes and characteristics of the measurement high frequency magnetic field generator 2 and the reference high frequency magnetic field generator 2R, the intensity of the noise component $\alpha_{MW1}$ of the first fluorescence sensor signal PL due to the noise component of the measurement microwave and the intensity of the noise component $\alpha_{MW2}$ of the second fluorescence sensor signal ref1 due to the noise component of the reference microwave are also different. In such a case, a first static magnetic field being applied to the measurement magnetic resonance member 1 and a second static magnetic field being applied to the reference magnetic resonance member 1R are set so that the intensities of the noise components $\alpha_{MW1}$ and $\alpha_{MW2}$ match each other.

In the third embodiment, for example, the reference static magnetic field generator 3R is an electromagnet, and the intensity of the second static magnetic field generated by the reference static magnetic field generator 3R is adjusted.

In the above-mentioned case, the first fluorescence sensor signal PL(t) and the second fluorescence sensor signal ref1(t) are shown below.

$$PL(t) = (\alpha_{init} + \alpha_{MW1}(t) + \alpha_{AC}(t)) \times (I_{laser} + I_{noise}).$$

$$ref1 = \beta \times (\alpha_{init} + \alpha_{MW2}(t)) \times (I_{laser} + I_{noise}).$$

Therefore, the CMR signal CMR_SIG(t) in this case is expressed by the following equation.

$$CMR\_SIG(t) = PL(t) - ref1/\beta = (\alpha_{MW1}(t) - \alpha_{MW2}(t)) \times \alpha_{AC}(t) \times (I_{laser} + I_{noise}).$$

In addition, the intensity of the second static magnetic field generated by the reference static magnetic field generator 3R is adjusted so that $\alpha_{MW1}(t) - \alpha_{MW2}(t) = 0$. Alternatively, instead of the above configuration, the intensity of the first static magnetic field may be adjusted in the same manner.

Note that the other configurations and operations of the measurement device according to the third embodiment are the same as those explained in the first embodiment or the second embodiment. Therefore, the explanations of the other configurations and operations of the measurement device according to the third embodiment will be omitted.

As mentioned above, according to the third embodiment, even when the intensities of the measurement microwave and the reference microwave are different, the noise component in the measurement value due to the noise component of the microwave is effectively suppressed (reduced), thereby improving the measurement accuracy.

FOURTH EMBODIMENT

In a fourth embodiment, when the intensities of the measurement microwave and the reference microwave are different due to, for instance, the characteristics of the power divider 11a, or the differences in the shapes and characteristics of the measurement high frequency magnetic field generator 2 and the reference high frequency magnetic field generator 2R, the intensity of the noise component $\alpha_{MW1}$ of the first fluorescence sensor signal PL due to the noise component of the measurement microwave and the intensity of the noise component $\alpha_{MW2}$ of the second fluorescence sensor signal ref1 due to the noise component of the reference microwave are also different. In such a case, a pulse width of the measurement microwave for the electron spin quantum operation of the measurement magnetic resonance member 1 and a pulse width of the reference microwave for the electron spin quantum operation of the reference magnetic resonance member 1R are set so that the intensities of the noise components $\alpha_{MW1}$ and $\alpha_{MW2}$ match each other.

That is, in the same manner as the third embodiment, the pulse width of the reference microwave is adjusted so that $\alpha_{MW1}(t) - \alpha_{MW2}(t) = 0$. Alternatively, instead of the above configuration, the pulse width of the measurement microwave may be adjusted in the same manner.

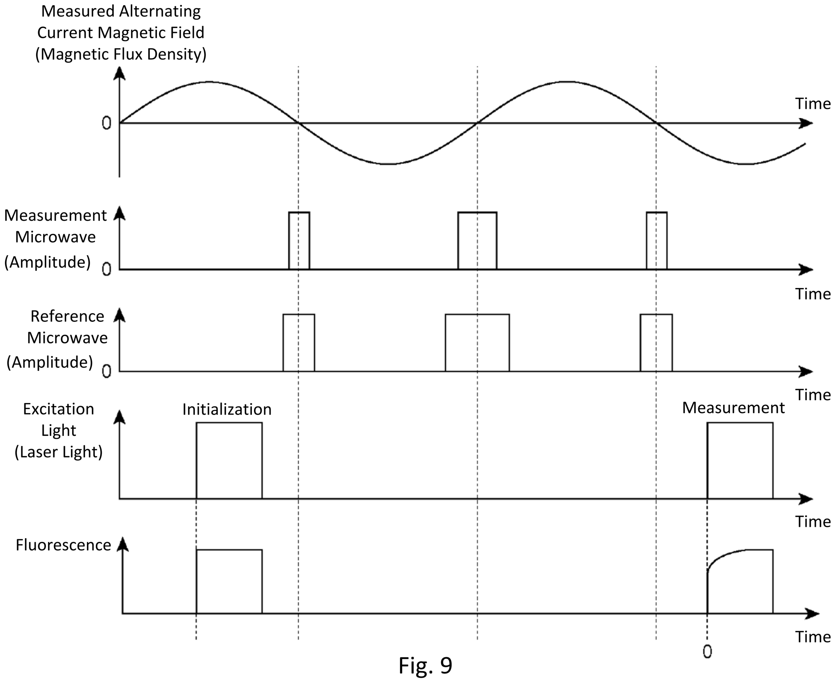

Fig. 9 is a diagram that shows an example of the pulse width of the measurement microwave and the pulse width of the reference microwave according to the fourth embodiment. When the intensity of the reference microwave is lower than that of the measurement microwave, as shown in, for instance, Fig. 9, the pulse width of the reference microwave is set to be wider than the pulse width of the measurement microwave. On the other hand, when the intensity of the reference microwave is higher than that of the measurement microwave, the pulse width of the reference microwave is set to be narrower than the pulse width of the measurement microwave.

Specifically, in the fourth embodiment, the high frequency power source 11 continuously outputs the high frequency current. Further, a switch circuit is respectively provided between the power divider 11a and the measurement high frequency magnetic field generator 2, and between the power divider 11a and the reference high frequency magnetic field generator 2R. A period, during which each switch circuit is turned ON (i.e., the above-mentioned pulse width), is adjusted by the measurement control part 41.

Note that the other configurations and operations of the measurement device according to the fourth embodiment are the same as those explained in the first embodiment or the second embodiment. Therefore, the explanations of the other configurations and operations of the measurement device according to the fourth embodiment will be omitted.

As mentioned above, according to the fourth embodiment, even when the intensities of the measurement microwave and the reference microwave are different, the noise component in the measurement value due to the noise component of the microwave is effectively suppressed (reduced), thereby improving the measurement accuracy.

FIFTH EMBODIMENT

In a fifth embodiment, the reference magnetic resonance member 1R (i.e., the reference sensor part 10R) is arranged at a position (adjacent to the measurement magnetic resonance member 1) in which external electromagnetic waves being incident on the measurement magnetic resonance member 1 are incident. The measurement magnetic resonance member 1 and the reference magnetic resonance member 1R are each a magnetic resonance member of the same type of color center containing impurities and defects (for instance, a diamond member with an NV center), and are arranged so that the arrangement directions of the impurities and the defects are the same as each other. As a result, the measurement sensor part 10 and the reference sensor part 10R have the same sensitivity to the external electromagnetic waves.

Note that the other configurations and operations of the measurement device according to the fifth embodiment are the same as those explained in any of the other embodiments. Therefore, the explanations of the other configurations and operations of the measurement device according to the fifth embodiment will be omitted.

As mentioned above, according to the fifth embodiment, the influence of the external electromagnetic waves on the measurement values is suppressed (reduced), and as a result, the measurement values of the measured field can be derived with higher accuracy.

SIXTH EMBODIMENT

A measurement device according to a sixth embodiment has a flux transformer. In addition, the above-mentioned measured field is a magnetic field, which is applied to the measurement magnetic resonance member 1 (while not being applied to the reference magnetic resonance member 1R) by a secondary coil of the flux transformer.

Specifically, a primary coil of the flux transformer senses a magnetic field at a position of the primary coil (i.e., an original measurement position). Further, the measurement sensor part 10 measures a magnetic field induced by the secondary coil at a position of the secondary coil which is spaced apart from the primary coil.

Note that the other configurations and operations of the measurement device according to the sixth embodiment are the same as those explained in any of the other embodiments. Therefore, the explanations of the other configurations and operations of the measurement device according to the sixth embodiment will be omitted.

As mentioned above, according to the sixth embodiment, it is possible to separate the reference sensor part 10R together with the measurement sensor part 10 from the original measurement position (the position of the primary coil). Further, the secondary coil can easily apply the measured magnetic field only to the measurement sensor part 10 out of the measurement sensor part 10 and the reference sensor part 10R. Therefore, since the reference sensor part 10R can be magnetically separated from the measurement sensor part 10, the measurement values can be derived with higher accuracy.

Note that various changes and modifications to the embodiments described above will be apparent to one having ordinally skill in the art. Such the changes and modifications may be made without departing from the spirit and scope of the subject matter and without diminishing the intended advantages. That is, it is intended that such the changes and modifications are included within the scope of the claims.

For example, in any of the above-mentioned first to sixth embodiments, when necessary, an amplifier may be provided between the high frequency power source 11 and the power divider 11a.

Furthermore, in any of the above-mentioned first to sixth embodiments, an optical (light) regulator (adjuster) (for instance, an ND filter or an iris) may be provided between the light distributor 21 and the reference sensor part 10R, instead of the coefficient part 31a, to adjust the amount of the incident light on the reference sensor part 10R so that the intensity of the second fluorescence sensor signal ref1 becomes $1/\beta$.

INDUSTRIAL APPLICABILITY

The present invention can be applicable to, for instance, a measurement device that uses optically detected magnetic resonance.

**Claims**

1.    A measurement device comprising:

> a measurement magnetic resonance member capable of an electron spin quantum operation by a measurement microwave, a measured field being applied to the measurement magnetic resonance member;
> a measurement high frequency magnetic field generator which performs the electron spin quantum operation of the measurement magnetic resonance member by the measurement microwaves in accordance with a predetermined measurement sequence;
> a reference magnetic resonance member capable of an electron spin quantum operation by a reference microwave, the measured field being not applied to the reference magnetic resonance member;
> a reference high frequency magnetic field generator which performs the electron spin quantum operation of the reference magnetic resonance member by the reference microwave in accordance with the predetermined measurement sequence;
> a high frequency power source which generates a high frequency current for the measurement microwave and the reference microwave;
> a power divider which distributes the high frequency current to the measurement high frequency magnetic field generator and the reference high frequency magnetic field generator;
> a light emitting device which emits excitation light to be irradiated to the measurement magnetic resonance member and the reference magnetic resonance member;
> an optical distributor which distributes the excitation light to the measurement magnetic resonance member and the reference magnetic resonance member;
> a measurement light receiving device which receives fluorescence emitted by the measurement magnetic resonance member in response to the excitation light and generates a first fluorescence sensor signal corresponding to an intensity of the received fluorescence;
> a reference light receiving device which receives fluorescence emitted by the reference magnetic resonance member in response to the excitation light and generates a second fluorescence sensor signal corresponding to an intensity of the received fluorescence; and
> an arithmetic processing part which derives a measurement value based on the first fluorescence sensor signal and the second fluorescence sensor signal.

2. A measurement method comprising:

creating a state in which a measured field is applied to a measurement magnetic resonance member capable of an electron spin quantum operation by a measurement microwave and the measured field is not applied to a reference magnetic resonance member capable of an electron spin quantum operation by a reference microwave;

in the state, performing the electron spin quantum operation of the measurement magnetic resonance member by the measurement microwave and performing the electron spin quantum operation of the reference magnetic resonance member by the reference microwave according to a predetermined measurement sequence by generating the measurement microwave and the reference microwave due to distribution of a high frequency current to a measurement high frequency magnetic field generator and a reference high frequency magnetic field generator;

in the state, distributing excitation light to the measurement magnetic resonance member and the reference magnetic resonance member to irradiate the excitation light to the measurement magnetic resonance member and the reference magnetic resonance member;

receiving fluorescence emitted in response to the excitation light by the measurement magnetic resonance member to generate a first fluorescence sensor signal corresponding to an intensity of the received fluorescence, and receiving fluorescence emitted in response to the excitation light by the reference magnetic resonance member to generate a second fluorescence sensor signal corresponding to an intensity of the received fluorescence; and

deriving a measurement value based on the first fluorescence sensor signal and the second fluorescence sensor signal.

3. The measurement method according to claim 2,
wherein the measurement value is derived based on a common mode rejection signal obtained by performing common mode rejection on the first fluorescence sensor signal based on the second fluorescence sensor signal.

4. The measurement method according to claim 3,

wherein a reference light sensor signal is generated by receiving reference light obtained by branching the excitation light; and
the measurement value is derived based on the common mode rejection signal and the reference light sensor signal.

5. The measurement method according to claim 3,
wherein a first static magnetic field applied to the measurement magnetic resonance member and a second static magnetic field applied to the reference magnetic resonance member are set so that an intensity of a noise component of the first fluorescence sensor signal caused by a noise component of the measurement microwave and an intensity of a noise component of the second fluorescence sensor signal caused by a noise component of the reference microwave match each other.

6. The measurement method according to claim 3,
wherein a pulse width of the measurement microwave for the electron spin quantum operation of the measurement magnetic resonance member and a pulse width of the reference microwave for the electron spin quantum operation of the reference magnetic resonance member are set so that an intensity of a noise component of the first fluorescence sensor signal caused by a noise component of the measurement microwave and an intensity of a noise component of the second fluorescence sensor signal caused by a noise component of the reference microwave match each other.

7. The measurement method according to claim 2,

wherein the reference magnetic resonance member is arranged at a position where an external electromagnetic wave, which is incident on the measurement magnetic resonance member, is incident on the reference magnetic resonance member, and
the measurement magnetic resonance member and the reference magnetic resonance member are magnetic resonance members of the same type of color center containing impurities and defects, and are arranged so that arrangement directions of the impurities and the defects are the same as each other.

8. The measurement method according to claim 2,

wherein the measured field is a magnetic field applied to the measurement magnetic resonance member by a secondary coil of a flux transformer.

Fig. 1

Measured Alternating Current Magnetic Field (Magnetic Flux Density)

Microwave (Amplitude)

Excitation Light (Laser Light)

Fluorescence

Initialization

Measurement

Fig. 2

EP 4 657 104 A1

Fig. 3

Transmittance

Frequency (kHz)

Fig. 4

```
                    ┌─────────────────┐
                    │      Start      │
                    └─────────────────┘
                             │
                             ▼                    S1
                    ┌─────────────────────┐
                    │ Starting Measurement│
                    │       Sequence      │
                    └─────────────────────┘
                             │
                             ▼                    S2
                    ┌──────────────────────────┐
                    │ Detecting First and Second│
                    │ Fluorescence Sensor Signals During│
                    │ Irradiation Period of Measurement│
                    │          Light           │
                    └──────────────────────────┘
                             │
                             ▼                    S3
                    ┌─────────────────────┐
                    │  Deriving CMR Signal│
                    └─────────────────────┘
                             │
                             ▼                    S4
                    ┌─────────────────────────┐
                    │   Digitizing CMR Signal │
                    └─────────────────────────┘
                             │
                             ▼                    S5
                    ┌─────────────────────┐
                    │    Noise Removal    │
                    └─────────────────────┘
                             │
                             ▼                    S6
                    ┌─────────────────────────────────┐
                    │ Deriving Measured Magnetic Field (such as│
                    │ Magnetic Flux Density) based on CMR Signal│
                    └─────────────────────────────────┘
                             │
                             ▼
                    ┌─────────────────┐
                    │       End       │
                    └─────────────────┘
```

Fig. 5

Fig. 6

Fig. 7

Fig. 8

Measured Alternating
Current Magnetic Field
(Magnetic Flux Density)

0 — Time

Measurement
Microwave
(Amplitude) 0 — Time

Reference
Microwave
(Amplitude) 0 — Time

Excitation
Light
(Laser Light)

Initialization    Measurement

Time

Fluorescence

0

Time

Fig. 9

## INTERNATIONAL SEARCH REPORT

| International application No. |
|---|
| **PCT/JP2023/028771** |

**A. CLASSIFICATION OF SUBJECT MATTER**

***G01R 33/26***(2006.01)i; ***G01N 21/64***(2006.01)i; ***G01N 24/00***(2006.01)i; ***G01R 33/032***(2006.01)i
FI:   G01R33/26; G01N21/64 Z; G01N24/00 P; G01R33/032

According to International Patent Classification (IPC) or to both national classification and IPC

**B. FIELDS SEARCHED**

Minimum documentation searched (classification system followed by classification symbols)

G01R33/00 - 33/26; 33/28 - 33/64; G01N1/62 - 21/74; 22/00 - 22/04; 24/00 - 24/14

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | CN 101430371 A (YANG, Wenhui et al.) 13 May 2009 (2009-05-13)<br>page 1, lines 3-4, page 7, line 19 to page 8, line 14, page 9, lines 8-11, fig. 1-2 | 1-3, 8 |
| Y | JP 01-199181 A (MITSUBISHI ELECTRIC CORPORATION) 10 August 1989 (1989-08-10)<br>page 1, lower right column, line 14, page 3, lower left column, line 12 to lower right column, line 4, page 4, lower left column, line 7 to lower right column, line 12, fig. 2, 9 | 1-3, 8 |
| Y | JP 2022-177757 A (SUMIDA CORPORATION) 01 December 2022 (2022-12-01)<br>paragraphs [0001], [0047], fig. 9 | 8 |
| A | JP 2017-227482 A (SEIKO EPSON CORP.) 28 December 2017 (2017-12-28)<br>entire text, all drawings | 1-8 |
| A | JP 2021-189148 A (SUMIDA CORPORATION) 13 December 2021 (2021-12-13)<br>entire text, all drawings | 1-8 |
| A | JP 2016-50784 A (NIKKA DENSOKU KK) 11 April 2016 (2016-04-11)<br>entire text, all drawings | 1-8 |

☑ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| International application No. |
| --- |
| **PCT/JP2023/028771** |

**C.     DOCUMENTS CONSIDERED TO BE RELEVANT**

| Category* | Citation of document, with indication, where appropriate, of the relevant passages | Relevant to claim No. |
| --- | --- | --- |
| A | WO 2018/155504 A1 (SUMITOMO ELECTRIC INDUSTRIES, LTD.) 30 August 2018 (2018-08-30)<br>entire text, all drawings | 1-8 |
| A | JP 11-330768 A (SHIMADZU CORP.) 30 November 1999 (1999-11-30)<br>entire text, all drawings | 1-7 |

Form PCT/ISA/210 (second sheet) (January 2015)

## INTERNATIONAL SEARCH REPORT
### Information on patent family members

International application No.

**PCT/JP2023/028771**

| Patent document cited in search report | | | Publication date (day/month/year) | Patent family member(s) | | | Publication date (day/month/year) |
|---|---|---|---|---|---|---|---|
| CN | 101430371 | A | 13 May 2009 | (Family: none) | | | |
| JP | 01-199181 | A | 10 August 1989 | (Family: none) | | | |
| JP | 2022-177757 | A | 01 December 2022 | WO | 2022/244399 | A1 | |
| JP | 2017-227482 | A | 28 December 2017 | US entire text, all drawings | 2017/0363695 | A1 | |
| JP | 2021-189148 | A | 13 December 2021 | (Family: none) | | | |
| JP | 2016-50784 | A | 11 April 2016 | (Family: none) | | | |
| WO | 2018/155504 | A1 | 30 August 2018 | US entire text, all drawings EP CN | 2020/0057117 3588117 110325869 | A1 A1 A | |
| JP | 11-330768 | A | 30 November 1999 | (Family: none) | | | |

Form PCT/ISA/210 (patent family annex) (January 2015)

**REFERENCES CITED IN THE DESCRIPTION**

**Patent documents cited in the description**

- JP 2019138772 A